# EUROPÄISCHE PATENTSCHRIFT

(11) **EP 0 751 563 B1**
(45) Veröffentlichungstag und Bekanntmachung des Hinweises auf die Patenterteilung: **27.11.2002**
(21) Anmeldenummer: 96109895.1
(22) Anmeldetag: 19.06.1996
(51) Int. Cl.: H01L 23/40, H05K 3/30

(54) **Einrichtung zum Halten eines elektrischen Bauelements an einem Trägerteil**
Apparatus holding an electric device to a supporting part
Appareil pour le serrage d'un dispositif électrique sur un dispositif de support

(30) Priorität: 30.06.1995 DE 29510701 U
(43) Veröffentlichungstag der Anmeldung: 02.01.1997
(73) Patentinhaber: SIEMENS AKTIENGESELLSCHAFT, 80333 München (DE)
(72) Erfinder: Resch, Reinhold, Ing., 80687 München (DE)

(56) Entgegenhaltungen:
- DE-U- 8 618 283
- DE-U- 8 811 128
- US-A- 5 040 096
- PATENT ABSTRACTS OF JAPAN vol. 013, no. 088 (E-721), 28.Februar 1989 & JP 63 266858 A (HITACHI LTD), 2.November 1988,
- "COOLING ENHANCEMENT OF INTEL 386/486 BY CLIP-ON HEAT SINK" IBM TECHNICAL DISCLOSURE BULLETIN, Bd. 33, Nr. 2, 1.Juli 1990, Seite 218/219 XP000123594

## Beschreibung

Die Erfindung bezieht sich auf eine Einrichtung zum Halten eines elektrischen Bauelementes an einem Trägerteil mittels einer bügelartig gebogenen federelastischen Klammer, die mit zumindest einem Ende am Trägerteil verankert ist und die mit einem mittleren Abschnitt an einer dem Trägerteil abgewandten Andruckseite des Bauelementes unter Vorspannung anliegt.

Derartige Halteeinrichtungen werden z.B. bei Flachbaugruppen verwendet, bei denen das schienenartige Trägerteil auf der Leiterplatte befestigt ist. Die senkrecht zur Leiterplatte stehenden Bauelemente werden mittels der Klammer flach gegen die als Kühlkörper dienende Schiene gedrückt, so daß die entstehende Wärme abgeführt werden kann. Das Trägerteil dient aber auch zur Fixierung des Bauelementes im Transportfall.

Bisher war es üblich die Klammer an einem Ende in eine Öffnung des Trägerteils einzuhaken und als einseitig eingespannte freiragende Blattfeder mit dem anderen Ende auf das Bauelement aufzusetzen. Die Klammer ist mit zwei seitlich freigestanzten Schenkeln zu versehen, die an der Andruckseite vorbei bis in den Bereich von seitlichen Mantelflächen des Bauelements hinein abgebogen sind und das zwischen der Klammer und dem Trägerteil einspannte Bauelement seitlich zu fixieren. Eine solche Klammer ist bekannt aus der DE-U-86 18 283. Die einseitige Einhängung der Klammer führt zu einem hohen Biegemoment mit der Gefahr der Deformation der Klammer sowie zu hohen Klemmkräfte am Trägerteil mit der Gefahr einer Beschädigung von dessen Oberfläche führen. Daraus ergeben sich große Unterschiede bei den auf das Bauelement einwirkenden Federkräfte.

Ferner ist es üblich, eine Klammer zu verwenden, die sich im wesentlichen in der Längsrichtung des Trägerteils parallel zur Leiterplatte erstreckt. Ihre Seitenschenkel sind in speziell gebohrte Durchbrüche der Schiene eingerastet. Aus fertigungstechnischen Gründen ist der Abstand zwischen den Seitenschenkeln der Klammer größer als das Bauelement breit. Dadurch ist es möglich, daß das Bauelement durch die Erschütterung des Transports seitlich verrutscht und daß dadurch die eingelöteten Anschlußbeinchen abbrechen.

Der Erfindung liegt die Aufgabe zugrunde, eine Einrichtung zu schaffen, die mit geringem Aufwand herstellbar und montierbar ist und die das Bauelement zuverlässig fixiert.

Diese Aufgabe wird durch die Erfindung gemäß Anspruch 1 gelöst. Bei der gabelartigen mit drei Schenkeln versehenen Klammer können die Abstände zwischen den einzelnen Fingern beim Ausstanzen genau auf die Maße des Bauelements abgestimmt werden. Der mittlere Finger der Klammer dient dem Andrücken des Bauelementes gegen das Trägerteil. Er ist entsprechen gegenüber den seitlichen Fingern abgespreizt, so daß das Bauelement leichter unter die Klammer geschoben werden kann. Die seitlichen Finger liegen sind mit ihren freien Enden am Trägerteil verankert, so daß die Klammer mit beiden Enden am Trägerteil lagegenau festgelegt ist. Die Abweichungen bei den Einspannkräften für das Bauelement sind so gering, daß sie genau auf ein Maß abgestimmt werden können, das ein sicheres Klemmen gewährleistet.

Zwischen den seitlichen Schenkeln und den seitlichen Mantelfächen des Bauelements ergibt sich ein längere Überschneidung mit einer entsprechend längeren seitlichen Führung des Bauelements. Dieses ist somit Kippsicher gehalten, wodurch sich die Gefahr einer Lageveränderung bei Transportvorgängen verringert. Ein Brechen der Anschlußbeinchen wird somit weitgehend verhindert.

Nach einer vorteilhaften Weiterbildung der Erfindung sind die beidseitigen Schenkel an ihren Enden einstückig über einen Quersteg miteinander verbunden. und dadurch gegeneinander stabilisiert.

Nach einer anderen Weiterbildung der Erfindung sind die beiden Enden der Klammer hakenartig aufeinander zugebogen und hintergreifen Halteflächen des Trägerteils. Eine derartige Klammer kann auch nach dem Einlöten des Bauelements soweit aufgebogen werden, daß die federnden Schenkel in die Halteflächen eingeschnappt werden können.

Nach einer anderen Weiterbildung der Erfindung ist das Trägerteil aus einer stranggepreßten Profilschiene hergestellt und sind die Halteflächen an durchgehenden Haltenuten der Profilschiene ausgebildet. Da sich die Haltenuten über die gesamte Länge der Profilschiene erstrecken, ist es möglich, die Klammer ohne jede weitere vorbereitende Maßnahme an beliebigen Stellen je nach Bedarf anzubringen. Spezielle Bohrungen sind dafür nicht erforderlich, d.h. daß unabhängig von der Lage und Breite der einzelnen Federklammern stets das selbe Trägerteil verwendet werden kann.

Im Folgenden wird die Erfindung anhand eines in der Zeichnung dargestellten Ausführungsbeispieles näher erläutert.
- Figur 1: zeigt eine stirnseitige Ansicht eines Trägerteils mit einem elektrischen Bauelement und einer Klammer,
- Figur 2: eine Seitenansicht der Teile nach Figur 1.

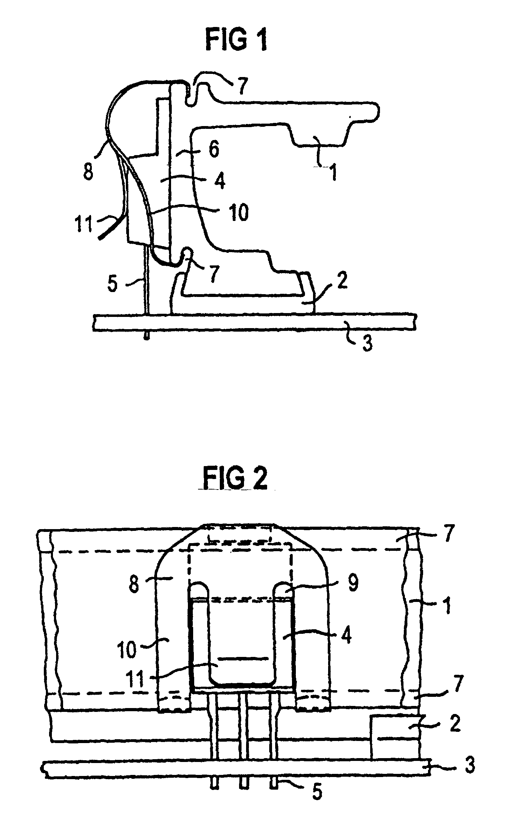

Nach den Figuren 1 und 2 ist ein aus einer stranggepreßten Profilschiene gebildetes Trägerteil 1 mittels eines Haltefußes 2 an einer Leiterplatte 3 an einer elektronischen Baugruppe befestigt. In die Leiterplatte 3 ist ein elektronisches Bauelement 4 mit seinen Anschlußbeinchen 5 eingelötet. Das Bauelement 4 ist senkrecht stehend angeordnet und liegt mit seiner Basisfläche flach an einer zur Leiterplatte 3 senkrecht stehenden Wand 6 des Trägerteils 1 an. Dieses ist in seinem oberen und unteren Bereich mit durchgehenden Haltenuten 7 versehen, in die die abgewinkelten Enden einer bügelartig gebogenen federnden Halteklammer 8 eingreifen.

Die Halteklammer 8 ist durch zwei schlitzartige Ausnehmungen 9 in drei Schenkel unterteilt, von denen die beiden äußeren seitlichen Schenkel 10 mit knappem Abstand seitlich am Bauelement 4 vorbeigeführt sind und mit ihrem freien Ende in eine der Haltenuten 7 eingreifen. Der mittlere Schenkel ist freiragend ausgebildet und dient als Druckschenkel 11 für das Bauelement 4. Er ist gegenüber den seitlichen Schenkeln 10 soweit abgespreizt, daß er an der dem Trägerteil 1 abgewandten Seite des Bauelements 4 zur Anlage kommt und dieses gegen das Trägerteil 1 drückt.

Dadurch wird das Bauelement 4 mechanisch an dem Trägerteil 1 gesichert und es kommt zu einer großflächigen Anlage am Trägerteil 1. Dieses ist mittels großflächiger Längsrippen als Kühlkörper ausgebildet, so daß die im thermisch belasteten Bauelement 4 entstehende Betriebswärme sicher abgeführt wird. Die Klammer 8 ist an ihrem den seitlichen Schenkeln 10 abgewandten Ende in ihrer Breite verjüngt. Damit ergibt sich eine kürzere Eingriffslänge in die entsprechende Haltenut 7. Die Klammer 8 ist somit an drei Punkten am Trägerteil 1 gehalten, wodurch ein Verkanten vermieden wird.

## Patentansprüche

1. Einrichtung zum Halten eines elektrischen Bauelements (4) an einem Trägerteil (1) mittels einer bügelartig gebogenen federelastischen Klammer (8) die mit zumindest einem Ende am Trägerteil (1) verankert ist und die mit einem mittleren Abschnitt an einer dem Trägerteil (1) abgewandten Andruckseite des Bauelementes (4) unter Vorspannung anliegt, wobei die Klammer (8) zwei seitliche freigestanzte Schenkel (10) aufweist, die an der Andruckseite vorbei bis in den Bereich der seitlichen Mantelflächen des Bauelements (4) hinein abgebogen sind und das Bauelement (4) gegen seitliches Verschieben fixieren,
**dadurch gekennzeichnet,**
**daß** die Schenkel an den Mantelflächen entlang zum Ende des Bauelements (4) geführt sind und daß die freien Enden der Schenkel (10) zum Trägerteil (1) hingebogen und an diesem verankert sind.

2. Einrichtung nach Anspruch 1,
**dadurch gekennzeichnet,**
**daß** die beiden seitlichen Schenkel (10) an ihren Enden einstückig über einen Quersteg miteinander verbunden sind.

3. Einrichtung nach Anspruch 1 oder 2,
**dadurch gekennzeichnet,**
**daß** die Enden der Klammer (8) hakenartig aufeinanderzugebogen sind und Halteflächen des Trägerteils (1) hintergreifen.

4. Einrichtung nach Anspruch 3,
**dadurch gekennzeichnet,**
**daß** das Trägerteil (1) aus einer stranggepreßten Profilschiene hergestellt ist und daß die Halteflächen an durchgehenden Haltenuten (7) der Profilschiene ausgebildet sind.

## Claims

1. Apparatus for holding an electrical device (4) on a supporting part (1) by means of an arcuately bent resilient clamp (8) which is anchored with at least one end on the supporting part (1) and which bears under prestress with a central portion against a pressure-bearing side of the device (4) facing away from the supporting part (1), the clamp (8) having two lateral punched-free legs (10), which are bent away past the pressure-bearing side into the region of the lateral generated surfaces of the device (4) and fix the device (4) against lateral displacement, **characterized in that** the legs are guided along the generated surfaces to the end of the device (4) and **in that** the free ends of the legs (10) are bent towards the supporting part (1) and anchored on the latter.

2. Apparatus according to Claim 1, **characterized in that** the two lateral legs (10) are integrally connected to each other at their ends by means of a cross-piece.

3. Apparatus according to Claim 1 or 2, **characterized in that** the ends of the clamp (8) are bent towards each other in a hook-like manner and engage behind holding surfaces of the supporting part (1).

4. Apparatus according to Claim 3, **characterized in that** the supporting part (1) is produced from an extruded profiled rail and **in that** the holding surfaces are formed on continuous holding grooves (7) of the profiled rail.

## Revendications

1. Appareil pour le maintien d'un composant (4) sur un support (1) au moyen d'une pince (8) faisant ressort et pliée en forme de pièce recourbée en arc, dont au moins une extrémité est ancrée dans ledit support (1) et dont une partie centrale subit une précontrainte de manière à être adjacente à un côté du composant (4) subissant ainsi une pression, lequel est opposé au support (1), la pince (8) comprenant deux branches (10) latérales réalisées par découpage, lesquelles forment une courbure longeant le côté subissant une pression et allant jusqu'au niveau des faces latérales du composant (4) pour fixer latéralement ledit composant (4) de manière à éviter tout déplacement latéral, **caractérisé en ce que** les branches longent les faces latérales pour aller jusqu'à l'extrémité du composant (4) et **en ce que** les extrémités libres des branches (10) sont recourbées en direction du support (1) auquel elles sont fixées.

2. Appareil selon la revendication 1, **caractérisé en ce que** les deux branches latérales (10) sont unies en leurs extrémités par une traverse faite toute d'une pièce avec elles.

3. Appareil selon la revendication 1 ou 2, **caractérisé en ce que** les extrémités de la pince (8) sont recourbées en forme de crochets qui se regardent et s'accrochent par derrière à des surfaces de retenue du support (1).

4. Appareil selon la revendication 3, **caractérisé en ce que** le support (1) est réalisé au départ d'un rail profilé extrudé et **en ce que** les surfaces de retenue sont réalisées au niveau de rainures de retenue (7) ininterrompues sur le rail profilé.
